# EUROPÄISCHE PATENTANMELDUNG

(11) **EP 4 407 388 A1**
(43) Veröffentlichungstag der Anmeldung: **31.07.2024**
(21) Anmeldenummer: 23153923.0
(22) Anmeldetag: 30.01.2023
(51) Int. Cl.: G05B 13/02, G05B 19/418

(54) **KONFIGURATIONSVERFAHREN FÜR EINE ÜBERWACHUNGSVORRICHTUNG ZUR VERBESSERTEN QUALITÄTPROGNOSE VON WERKSTÜCKEN**

(71) Anmelder: Siemens Aktiengesellschaft, 80333 München (DE)
(72) Erfinder: Sadovoy, Alexandr, 13587 Berlin (DE)
(74) Vertreter: Siemens Patent Attorneys

(57) **Zusammenfassung**

Die Erfindung betrifft ein Verfahren (100) zum Konfigurieren einer Überwachungsvorrichtung (30), die zum Überwachen eines Produktionsprozesses (15) in einer Produktionsanlage (10) zur Qualitätsvorhersage ausgebildet ist. Darin wird eine Prozess-Variable (16) erfasst und anhand dieser eine Mehrzahl an Aggregations-Variablen (45) ermittelt. Ebenso wird ein Qualitäts-Parameter (22) fasst. Es werden mehrere Aggregations-Variablen (45) und der Qualitäts-Parameter (22) zu einem Werkstück-Datensatz (49) kombiniert. Weiter wird je eine Abhängigkeit (46) zwischen je einer Aggregations-Variable (45) und dem Qualitäts-Parameter (22) ermittelt und unter den Aggregations-Variablen (45) anhand der ermittelten Abhängigkeiten (46) eine Vorhersage-Variable (54) ermittelt. Ferner wird die Vorhersage-Variable (54) für den Betrieb der Überwachungsvorrichtung (30) als zu überwachende Größe des Produktionsprozesses (15) vorgegeben. Weiter betrifft die Erfindung ein Computerprogrammprodukt (60), mit dem ein solches Verfahren (100) durchführbar ist. Die Erfindung betrifft auch ein Überwachungsverfahren (200) für einen Produktionsprozess (15) an eine Produktionsanlage (10). Ferner betrifft die Erfindung eine Produktionsanlage (10), die mit einer solchen Überwachungsvorrichtung (30) ausgestattet ist.

## Beschreibung

Die Erfindung betrifft ein Verfahren zum Konfigurieren einer Überwachungsvorrichtung, die zu einer Produktionsanlage gehört. Weiter betrifft die Erfindung ein Überwachungsverfahren für einen Herstellungsprozess. Ebenso betrifft Erfindung ein Computerprogrammprodukt zum zumindest teilweisen Durchführen des Verfahrens zur Vorhersage der Qualitätsergebnisse. Ferner betrifft die Erfindung eine entsprechend konfigurierte Überwachungsvorrichtung und eine Produktionsanlage, die über eine solche Überwachungsvorrichtung verfügt.

Die Internationale Anmeldung WO 2022/063702 A1 offenbart ein Verfahren zur Qualitätskontrolle eines in Serie gefertigten Produkts, bei dem Parameter des Herstellungsprozesses aufgezeichnet werden. Das Produkt wird darauf einer Kontrolle unterzogen und auf Basis dessen eine Qualitätsbeurteilung durchgeführt. Die aufgezeichneten Parameter und die Qualitätsbeurteilung werden einem Machine-Learning-Modell zugeführt. Anhand der aufgezeichneten Parameter wird eine Qualitätsprognose durchgeführt und auf Übereinstimmung mit bzw. Abweichung von der Qualitätsbeurteilung durchgeführt. Es wird so ein Machine-Learning durchgeführt, durch das das Machine-Learning-Modell zum Erkennen von Ursachen von Qualitätsproblemen trainiert wird.

Produktionsanlagen weisen eine steigende Anzahl an Sensoren auf, so dass eine zunehmende Datenmenge zur Verfügung steht, die für ihre Überwachung in Betracht kommt. Ein sachgerechtes Konfigurieren einer Überwachungsvorrichtung für solche Produktionsanlagen wird dadurch komplexer und aufwendiger. Ebenso besteht Bedarf an flexiblen Produktionsanlagen, die schnell auf andere Produktionsprozesse umrüstbar sind und nach kurzer Anlaufzeit zuverlässig hohe Produktqualität bieten. Es besteht ein Bedarf an einer Möglichkeit, Überwachungsvorrichtungen von Produktionsanlagen schnell und weitestgehend selbsttätig zu konfigurieren.

Die Aufgabenstellung wird durch ein erfindungsgemäßes Verfahren zum Konfigurieren einer Überwachungsvorrichtung gelöst, die zu einer Produktionsanlage gehört. Die Überwachungsvorrichtung ist zu einem Überwachen eines Produktionsprozesses ausgebildet, der mittels der Produktionsanlage durchgeführt wird. Der Produktionsprozess kann ein zyklischer Produktionsprozess sein, bei dem Werkstücke in wiederholt gleicher Weise bearbeitet werden. Das Werkstück kann ein Rohling, ein bearbeitetet Rohling oder ein zu reparierendes Bauteil sein. Das Verfahren geht davon aus, dass die Überwachungsvorrichtung in einem Grundzustand vorliegt, in dem diese zumindest dazu geeignet ist, Eingaben zu empfangen, durch die eine als Vorhersage-Variable zu überwachende Prozess-Variable vorgebbar ist. Weiter kann die Überwachungsvorrichtung im Grundzustand frei von bekannten oder vermuteten Zusammenhängen sein, die eine angestrebte Qualität des Werkstücks beeinflussen, also frei von einer entsprechenden Konfiguration.

Das Verfahren umfasst einen ersten Schritt, in dem zumindest eine vorgebbare Prozess-Variable an einer Komponente der Produktionsanlage erfasst wird. Das Erfassen der vorgebbaren Prozess-Variable erfolgt bei einem Durchgang des Produktionsprozesses an einem Werkstück. Die Prozess-Variable kann eine Größe sein, die an der jeweiligen Komponente messbar ist, beispielsweise elektrische Stromstärke der Heizelemente oder Temperatur im Ofen bei einem Härtungsvorgang. Die zumindest eine Prozess-Variable ist eine zeitlich veränderliche Größe, so dass die im ersten Schritt erfasste Prozess-Variable als Zeitserie ausgebildet ist, also als Mehrzahl an Datenpunkten, die zeitlich sortierbar sind, beispielsweise anhand eines Zeitstempels. Die Prozess-Variable wird im ersten Schritt zumindest vorübergehend zumindest teilweise gespeichert und so für weitere Schritte bereitgestellt. Die Prozess-Variable kann durch einen Benutzer, eine Tabelle und/oder einen Algorithmus vorgegeben sein, beispielsweise eine Expertenwissen-Datenbank.

Weiter weist das Verfahren einen zweiten Schritt auf, in dem ein Erfassen eines vorgebbaren Qualitäts-Parameters des Werkstücks erfolgt. Der Qualitäts-Parameter kann eine physikalische Größe sein, die unmittelbar am Werkstück vorliegt und messbar ist. Beispielsweise kann eine Materialeigenschaft des Werkstücks oder eine Abweichung einer Materialeigenschaft von einem Nennwert ein Qualitäts-Parameter sein. Unter anderem kann eine solche Materialeigenschaft eine Härte oder Porosität des Werkstücks sein. Durch den Qualitäts-Parameter ist eine angestrebte Eigenschaft des Werkstücks quantifizierbar. Der Qualitäts-Parameter kann durch einen Benutzer, eine Tabelle und/oder einen Algorithmus vorgegeben sein, beispielsweise eine Expertenwissen-Datenbank. Darüber hinaus umfasst das Verfahren einen dritten Schritt, in dem Aggregations-Variablen anhand der zumindest einen Prozess-Variablen aus dem ersten Schritt ermittelt wird. Die Aggregations-Variablen stellen jeweils eine aus der als Zeitserie ausgebildeten Prozessvariablen abgeleitete Größe dar. Insbesondere können die Aggregations-Variablen statistische Größen der zumindest einen Prozess-Variable sein. Zumindest eine Aggregations-Variable kann ein Datenvolumen aufweisen, dass geringer ist als das Datenvolumen der zugrundeliegenden Prozess-Variable. Der dritte Schritt kann nach dem ersten Schritt oder zumindest teilweise gleichzeitig mit dem ersten Schritt durchgeführt werden.

Ferner umfasst das Verfahren einen vierten Schritt, in dem die Aggregations-Variablen mit dem Qualitäts-Parameter, der im zweiten Schritt erfasst wird, kombiniert wird und dadurch ein Werkstück-Datensatz gebildet wird. Dabei werden die Aggregations-Variablen mit dem Qualitäts-Parameter kombiniert, die zum gleichen Werkstück gehören. Der Werkstück-Datensatz umfasst dadurch werkstückspezifisch eine Mehrzahl an Aggregations-Variablen, bei denen ein Zusammenhang mit dem zugehörigen Qualitäts-Parameter denkbar ist. Des Weiteren kann der Werkstück-Datensatz frei von der Prozess-Variable sein, anhand der die darin gespeicherten Aggregations-Variablen ermittelt sind. Der vierte Schritt kann nach dem dritten Schritt oder zumindest teilweise gleichzeitig mit dem dritten Schritt durchgeführt werden. Weiter werden der erste bis vierte Schritt im erfindungsgemäßen Verfahren mehrfach durchgeführt und so eine Mehrzahl an Werkstück-Datensätzen bereitgestellt werden. Die Mehrzahl an Werkstück-Datensätzen wird für einen anschließenden fünften Schritt bereitgestellt.

Im fünften Schritt des erfindungsgemäßen Verfahrens erfolgt ein Ermitteln je einer Abhängigkeit zwischen mehreren der Aggregations-Variablen und dem Qualitäts-Parameter. Anhand einer ermittelten Abhängigkeit wird eine der Aggregations-Variablen als Vorhersage-Variable erkannt. Das Erkennen der jeweiligen Abhängigkeiten kann mittels eines Machine-Learning-Modells durchgeführt werden. Folglich wird im fünften Schritt erkannt, zwischen welcher einzelnen Aggregations-Variable oder mehreren Aggregations-Variablen und dem Qualitäts-Parameter ein aussagekräftiger Zusammenhang besteht. Dieser Zusammenhang ist durch die zumindest eine erkannte Abhängigkeit charakterisiert und quantifiziert erfassbar. Der fünfte Schritt kann mittels eines Machine-Learning-Modells durchgeführt werden, beispielsweise mit Decision Tree, Random Forest, Gradient Boost, XGB Boost oder Neuronalen Netz. Das Verfahren weist ferner einen sechsten Schritt auf, in dem die im fünften Schritt erkannte Vorhersage-Variable der Überwachungsvorrichtung als zu überwachende Größe des Produktionsprozesses vorgegeben wird. Dazu kann beispielsweise eine Bezeichnung der Vorhersage-Variable an die Überwachungsvorrichtung übertragen werden. Durch das Vorgehen der Vorhersage-Variable wird zumindest teilweise die Konfiguration der Überwachungsvorrichtung eingestellt.

Aus der als Zeitserie ausgebildeten Prozessvariable wird im erfindungsgemäßen Verfahren eine Mehrzahl an Aggregations-Variablen abgeleitet. Zeitserien sind in puncto Datenvolumen umfangreich, so dass das Verarbeiten zu Aggregations-Variablen eine Datenkomprimierung darstellt. Das Ermitteln der Aggregations-Variablen kann dadurch im Wesentlichen produktionsprozessbegleitend durchgeführt werden. Der im erfindungsgemäßen Verfahren erstellte Werkstück-Datensatz ist in puncto Datenvolumen klein, was deutlich die Anzahl der Dimensionen und die Komplexität des Machine-Learning_Models reduziert. Auch bei einer erhöhten Anzahl an Werkstück-Datensätzen ist deren Auswertung im fünften Schritt, also das Ermitteln von Abhängigkeiten, das zugrundeliegende Datenvolumen relativ gering, was wiederum ein beschleunigtes Ermitteln der Abhängigkeiten erlaubt. Der Erfindung liegt unter anderem die überraschende Erkenntnis zugrunde, dass Aggregations-Variablen als Vorhersage-Variablen für einen Qualitäts-Parameter zumindest hinreichend aussagekräftig sind. Das Erkennen einer Aggregations-Variable als Vorhersage-Variable erfordert kein Vorgeben von bekannten oder vermuteten Zusammenhängen innerhalb des Produktionsprozesses und ist dadurch selbsttätig durchführbar. Das Verfahren ist dazu geeignet, in einer Produktionsanlage schnell aussagekräftige Vorhersage-Variablen zu erzeugen und vorzugeben, was eine Prognose von Qualitätsergebnissen an bearbeiteten Werkstücken ermöglicht.

In einer Ausführungsform des beanspruchten Verfahrens werden anhand des Zeitstempels oder anhand des Werts der vorgebbaren Prozess-Variable, also von Zeitstempeln oder Werten einzelner Datenpunkte der Prozess-Variable, Datenpunkte ermittelt, die zu einer Nebenzeitaktion der entsprechenden Komponente gehören. Unter einer Nebenzeitaktion ist jegliche Betätigung der Komponente zu verstehen, in der keine produktive Aktivität des entsprechenden Produktionsprozesses vorliegt, beispielsweise bei einer Nebenzeitbewegung einer Werkzeugmaschine in einer anderen Prozessphase oder einem Leerlauf. Derartige Datenpunkte, die zu einer Nebenzeitaktion gehören, werden entfernt. Dadurch enthält die Prozess-Variable, anhand der die Aggregations-Variablen ermittelt werden, nur Datenpunkte, die den entsprechenden Produktionsprozess charakterisieren. Die Erzeugung irreführender Aggregations-Variablen wird so reduziert oder verhindert. Alternativ oder ergänzend kann die zumindest eine Prozess-Variable, die im dritten Schritt eingesetzt wird, mittels einer weiteren Prozess-Variable überprüft werden und so Datenpunkte erkannt werden, die zu einer Nebenzeitaktion gehören. Auch die so erkannten Datenpunkte werden entfernt. Mit einer derartigen Filterung ist Aggregations-Variablen mit gesteigerter Aussagekraft erstellbar.

In einer weiteren Ausführungsform des beanspruchten Verfahrens wird der fünfte Schritt, also das Ermitteln der Abhängigkeiten, mittels eines Machine-Learning-Modells durchgeführt. Ein derartiges Machine-Learning-Modell kann beispielsweise als ein Decision Tree, Random Forest, Gradient Boost, XGB Boost oder Neuronales Netz ausgebildet sein. Eine Vielzahl an Machine-Learning-Modellen sind dazu geeignet, Abhängigkeiten in Datensätzen wie den Werkzeug-Datensätzen schnell und zuverlässig zu ermitteln. Das im fünften Schritt eingesetzt Machine-Learning-Modell ist infolgedessen separat austauschbar. Dadurch ist das beanspruchte Verfahren in einfacher Weise dazu geeignet, auch künftige Machine-Learning-Modelle einzusetzen und deren technisches Potential auszunutzen.

Des Weiteren kann das Machine-Learning-Modell anhand einer Mehrzahl an Werkstück-Datensätzen trainiert sein, die gemäß dem ersten, zweiten, dritten und vierten Schritt bereitgestellt sind. Derartige Werkstück-Datensätze können beispielsweise durch ein Konfigurationsverfahren auf einer anderen Produktionsanlage gewonnen sein, oder aus vorherigen Durchgängen des beanspruchten Verfahrens. Das beanspruchte Verfahren ist folglich dazu geeignet, begleitend zum Betrieb der Produktionsanlage, also zum Produktionsprozess, Werkstück-Datensätze zu erstellen, die zu einem Weitertrainieren des Machine-Learning-Modells geeignet sind. Derartige weitere Werkstück-Datensätze werden jeweils zu weiteren Werkstücken erzeugt. Ein derartiges Weitertrainieren kann auf einer von der Produktionsanlage separaten Hardwareplattform erfolgen. Das Machine-Learning-Modell wird somit durch eine weitertrainierte Version während des Produktionsprozesses aktualisiert.

Die Leistungsfähigkeit des beanspruchten Verfahrens ist somit selbsttätig steigerbar.

Darüber hinaus kann im beanspruchten Verfahren eine der Aggregations-Variablen als Vorhersage-Variable erkannt werden, wenn zwischen der entsprechenden Aggregations-Variablen und dem Qualitäts-Parameter ein quantifizierbarer Zusammenhang, beispielsweise eine lineare oder nichtlineare Abhängigkeit, vorliegt, die durch einen Abhängigkeits-Koeffizienten charakterisiert ist. Wenn der Abhängigkeits-Koeffizient der entsprechenden Abhängigkeit einen vorgebbaren Schwellenwert betragsmäßig übersteigt. Durch den vorgebbaren Schwellenwert ist einstellbar, unterhalb welcher Stärke des vorliegenden quantifizierbaren Zusammenhangs diese im beanspruchten Verfahren ignoriert wird. Somit ist über den Schwellenwert vorgebbar, wie viele Aggregations-Variablen als Vorhersage-Variablen zu erwarten sind. Je weniger Vorhersage-Variablen wiederum für die Überwachungsvorrichtung im sechsten Schritt vorgegeben werden, umso effizienter ist der Produktionsprozess überwachbar. Durch den Schwellenwert ist auch der Einfluss einer Vorhersage-Variable auf den Qualitäts-Parameter quantifizierbar.

Ferner kann zumindest eine der Aggregations-Variablen als Maximum, Minimum, arithmetisches Mittel, geometrisches Mittel, oder als Standardabweichung der zugehörigen Prozess-Variablen ausgebildet sein. Diese stellen aus einer Zeitserie einfach ermittelbare Größen dar, die datenvolumensparend speicherbar sind, und somit gegenüber der zugrundeliegenden Prozess-Variable eine gesteigerte Komprimierung bieten. Für derartige statistische Funktionen sind effiziente Algorithmen, beispielsweise in sogenannten Funktionsbibliotheken, verfügbar, die ein schnelles Ermitteln der jeweiligen Aggregations-Variable erlauben. Alternativ oder ergänzend kann die Aggregations-Variable auch jegliche weitere statistische Größe sein, die aus der Prozess-Variable abgeleitet ist.

In einer weiteren Ausführungsform des beanspruchten Verfahrens kann zumindest eine der Aggregations-Variablen als Koeffizientensatz einer Vergleichsfunktion, beispielsweise einer Fitting-Funktion, ausgebildet sein. Der Koeffizientensatz kann eine oder mehrere Koeffizienten umfassen. Alternativ oder ergänzend kann zumindest eine der Aggregations-Variablen als Vergleichswert zu einem Modell-Ausgabewert eines Prozessmodells oder eines Teilprozessmodells ausgebildet sein. Das Prozessmodell bzw. der Teilprozessmodell kann als physikalisches Modell des Produktionsprozesses bzw. Teilproduktionsprozesses ausgebildet sein. Als Beispiel kann ein lineares oder exponentielles Model mit entsprechenden Koeffizientsätzen verwendet werden, um den Verlauf der Prozess-Variablen in der entsprechenden Prozessphase bei der Herstellung der Werkstücke abzubilden. Prozessmodelle oder Teilprozessmodelle stellen realitätstreue Abbildungen des zugrundeliegenden Produktionsprozesses dar, die durch das beanspruchte Verfahren mitgenutzt werden können. Weiter alternativ oder ergänzend kann die zumindest eine Aggregations-Variable als Prozessunterbrechungsangabe ausgebildet sein, die anhand der Prozess-Variable ermittelt wird, die im ersten Schritt erfasst wird. Die Prozessunterbrechungsangabe kann eine Dauer einer Unterbrechung oder eine Anzahl der Unterbrechungen des Produktionsprozesses anzeigen, einen Start- und Endzeitpunkt der Unterbrechung und/oder eine Häufigkeitsangabe von Unterbrechungen. Eine Prozessunterbrechungsangabe ist dazu geeignet, anzugeben, ob und wie stark mit einer rückläufigen Produktqualität zu rechnen ist. Beispielsweise kann ein zwischenzeitlicher Ausfall eines Heizelements bei einem Härteofen je nach Position im abgefahrenen Temperaturprofil unterschiedlich starke Auswirkungen auf den Härtungsvorgang haben. Das beanspruchte Verfahren ist insgesamt dazu geeignet, unter Hinzuziehung unterschiedlich gearteter Daten, also Prozess-Variablen, Aggregations-Variablen zu ermitteln. Hierdurch sind Zusammenhänge im Produktionsprozess in Form von Vorhersage-Variablen aufgreifbar, die für einen Benutzer nicht erkennbar sind. Die Überwachungsvorrichtung ist somit auf eine Vorhersage-Variable einstellbar, die über in Bezug auf einen Qualitäts-Parameter eine gesteigerte Aussagekraft aufweist.

Darüber hinaus können der erste bis sechste Schritt begleitend zum Produktionsprozess wiederholt durchgeführt werden. Hierdurch werden aus einer Vielzahl von Werkstücken Werkstück-Datensätze gewonnen, anhand derer das Machine-Learning-Modell, das im fünften Schritt eingesetzt wird, weitertrainierbar ist. Hierdurch wird insgesamt die Leistungsfähigkeit der Überwachungsvorrichtung weiter gesteigert.

Die zugrundeliegende Aufgabenstellung wird ebenso durch ein erfindungsgemäßes Qualitätsprognoseverfahren für einen Produktionsprozess gelöst, der mittels einer Produktionsanlage durchgeführt. Die Produktionsanlage umfasst zumindest eine Komponente, mit der der Produktionsprozess durchgeführt wird, beispielsweise einen Ofen für das Härten. Das Qualitätsprognoseverfahren umfasst einen ersten Schritt, in dem die Produktionsanlage in einem aktiven Betriebszustand bereitgestellt wird, in dem der zu überwachende Produktionsprozess abläuft. Insbesondere kann dabei ein Werkstück bearbeitet werden. Weiter wird im ersten Schritt zumindest eine Prozess-Variable erfasst. Weiter umfasst das Qualitätsprognoseverfahren einen zweiten Schritt, in dem basierend auf der erfassten Prozess-Variable zumindest eine Vorhersage-Variable ermittelt wird, die als eine aus der Prozess-Variable abgeleitete Aggregations-Variable ausgebildet sein kann. Ebenso gehört ein dritter Schritt zum beanspruchten Qualitätsprognoseverfahren, in dem anhand der zumindest einen Vorhersage-Variable ein Prognose-Wert ein für einen Qualitäts-Parameter eines Werkstücks ermittelt wird. Hierbei handelt es sich um einen erwarteten Qualitäts-Parameter. Der ermittelte Prognosewert wird im dritten Schritt mit einem zugehörigen vorgebbaren Sollwert oder zumindest einer vorgebbaren Toleranzgrenze verglichen, also eine Differenz zwischen diesen quantifiziert. Ferner weist das Qualitätsprognoseverfahren einen vierten Schritt auf, in dem eine Warnung an einen Benutzer und/oder eine Datenschnittstelle ausgegeben wird, wenn anhand des Vergleichens im dritten Schritt ein bestimmungswidriger Zustand der Produktionsanlage erkannt wird. Erfindungsgemäß ist die zumindest eine Vorhersage-Variable, die im zweiten Schritt ermittelt wird, durch ein Verfahren zum Konfigurieren der Überwachungsvorrichtung nach einer der oben skizzierten Ausführungsformen vorgegeben. Ein derartiges Qualitätsprognoseverfahren bietet eine zielgerichtete und sichere Erkennung eines Rückgangs der Qualität der Werkstücke, die im überwachten Produktionsprozess bearbeitet werden.

In einer Ausführungsform des beanspruchten Qualitätsprognoseverfahrens wird dessen dritter Schritt durchgeführt, während dessen erster Schritt durchgeführt wird. Dementsprechend wird während einer Bearbeitung des Werkstücks eine Prozess-Variable erfasst und anhand einer Untermenge der zum entsprechenden Produktionsprozess gehörigen Datenpunkte, beispielsweise seit dem Anfang der Bearbeitung des Werkstücks, der Prognose-wert ermittelt. Das beanspruchte Qualitätsprognoseverfahren ermittelt dadurch bereit vor Abschluss der zugrundeliegenden Bearbeitung des Werkstücks den Prognosewert für den Qualitäts-Parameter, der mit dem zugehörigen vorgebbaren Sollwert oder der vorgebbaren Toleranzgrenze verglichen wird. Dies erlaubt insbesondere bei langen Bearbeitungen, beispielsweise einer Härtung im Härteofen, eine frühzeitige Qualitätsprognose und entsprechend eine frühzeitige Reaktion auf drohende Qualitätseinbußen.

Alternativ kann zumindest der dritte Schritt des beanspruchten Qualitätsprognoseverfahrens dann durchgeführt werden, wenn der erste Schritt abgeschlossen ist. Dadurch sind alle Datenpunkte, die während der Bearbeitung des entsprechenden Werkstücks erzeugt werden, für die Ermittlung des Prognosewerts eingesetzt werden. Hierdurch werden unzutreffende Prognosewerte vermieden. Dies gilt insbesondere für Vorhersage-Variablen, also eine Aggregations-Variable, die sich erst durch die Dynamik der zugrundeliegenden Prozess-Variable ergibt. Dies kann beispielsweise ein arithmetisches Mittel eines Temperaturprofils sein, das zu Beginn des ersten Schritts noch bei Umgebungstemperatur steht.

Ob der dritte Schritt während des ersten Schritts oder nach dem ersten Schritt durchgeführt wird, kann beispielsweise durch einen Benutzer vorgegeben werden.

Die beschriebene Aufgabe wird auch durch ein erfindungsgemäßes Computerprogrammprodukt gelöst. Das Computerprogrammprodukt ist zu einem Empfangen von zumindest einer Prozess-Variable und zu einem Verarbeiten der Prozess-Variable ausgebildet. Durch das Verarbeiten der Prozess-Variable ist eine Vorhersage-Variable ermittelbar. Erfindungsgemäß ist das Computerprogrammprodukt dazu ausgebildet, ein Verfahren zum Konfigurieren einer Überwachungsvorrichtung gemäß einer der oben dargelegten Ausführungsformen durchzuführen. Das Computerprogrammprodukt kann das ausgebildet sein, auf einer Steuereinheit ausgeführt zu werden, die zur Produktionsanlage gehört, an der die durch das Computerprogrammprodukt empfangbare und verarbeitbare Prozess-Variable erfasst wird. Weiter kann das Computerprogrammprodukt monolithisch ausgebildet sein, also auf einer einzigen Hardware-Plattform ausführbar sein, beispielsweise einem Speicherprogrammierbaren Steuerung, kurz SPS, einem Leitrechner und/oder eine Operator Station, die mit der Produktionsanlage gekoppelt ist oder zu dieser gehört. Alternativ kann das Computerprogrammprodukt modular aufgebaut sein und eine Mehrzahl an Teilprogrammen umfassen, die auf separaten Hardware-Plattformen ausführbar sind und die über einen Datenaustausch zusammenwirken, um die Funktionalität des beanspruchten Verfahrens zu verwirklichen. Beispielsweise kann das beanspruchte Computerprogrammprodukt in Form von Teilprogrammen auf unterschiedlichen Computern einer Computer-Cloud ausführbar sein. Das Computerprogrammprodukt kann insbesondere als Software für ein Edge-Gerät oder eine Computer-Cloud ausgebildet sein. Weiter kann das Computerprogrammprodukt zumindest teilweise festverdrahtet ausgebildet sein, beispielsweise als Chip, Integrierte Schaltung oder FPGA. Alternativ oder ergänzend kann das Computerprogrammprodukt zumindest teilweise als Software ausgebildet sein.

Ferner wird die zugrundeliegende Aufgabe durch eine erfindungsgemäße Überwachungsvorrichtung gelöst, die zum Überwachen eines Produktionsprozesses ausgebildet ist, der mittels einer Produktionsanlage durchgeführt wird. Die Überwachungsvorrichtung ist dazu geeignet, zumindest eine Prozess-Variable zu empfangen und anhand dieser zumindest eine Vorhersage-Variable zu ermitteln. Erfindungsgemäß ist die Vorhersage-Variable mittels eines Verfahrens zum Konfigurieren einer Überwachungsvorrichtung nach einer der oben dargestellten Ausführungsformen ausgebildet. Alternativ oder ergänzend ist die Überwachungsvorrichtung dazu ausgebildet, ein Überwachungsverfahren nach einer der oben beschriebenen Ausführungsformen durchzuführen. Eine derartige Überwachungsvorrichtung erlaubt es, die zugehörige Produktionsanlage schnell einzurichten und gewährleistet eine zuverlässige Qualitätsprognose der damit bearbeiteten Werkstücke.

Ebenso wird die eingangs skizzierte Aufgabe durch eine erfindungsgemäße Produktionsanlage gelöst, die eine Mehrzahl an Komponenten umfasst, die jeweils zu einem Bearbeiten eines Werkstücks ausgebildet sind, insbesondere im Zuge eines Produktionsprozesses. Die Produktionsanlage umfasst auch eine Überwachungsvorrichtung, die mit den Komponenten verbunden ist. Erfindungsgemäß ist die Überwachungsvorrichtung nach einer der oben dargestellten Ausführungsformen ausgebildet. Derartige Produktionsanlagen bieten eine zuverlässige Prognose für die Qualität der damit bearbeiteten Werkstücke.

Die Erfindung wird im Folgenden anhand einzelner Ausführungsformen in Figuren näher erläutert. Die Figuren sind insoweit in gegenseitiger Ergänzung zu lesen, dass gleiche Bezugszeichen in unterschiedlichen Figuren die gleiche technische Bedeutung haben. Die Merkmale der einzelnen Ausführungsformen sind untereinander auch kombinierbar. Ferner sind die in den Figuren gezeigten Ausführungsformen mit den oben skizzierten Merkmalen kombinierbar. Es zeigen im Einzelnen:
- FIG 1: schematisch eine erste Ausführungsform des beanspruchten Konfigurationsverfahrens in einem ersten Stadium;
- FIG 2: schematisch eine zweite Ausführungsform des beanspruchten Konfigurationsverfahrens während dessen ersten oder zweiten Schritts;
- FIG 3: schematisch die erste Ausführungsform des beanspruchten Konfigurationsverfahrens in einem zweiten Stadium;
- FIG 4: schematisch die erste Ausführungsform des beanspruchten Konfigurationsverfahrens in einem dritten Stadium;
- FIG 5: schematisch eine erste Ausführungsform des beanspruchten Überwachungsverfahrens.

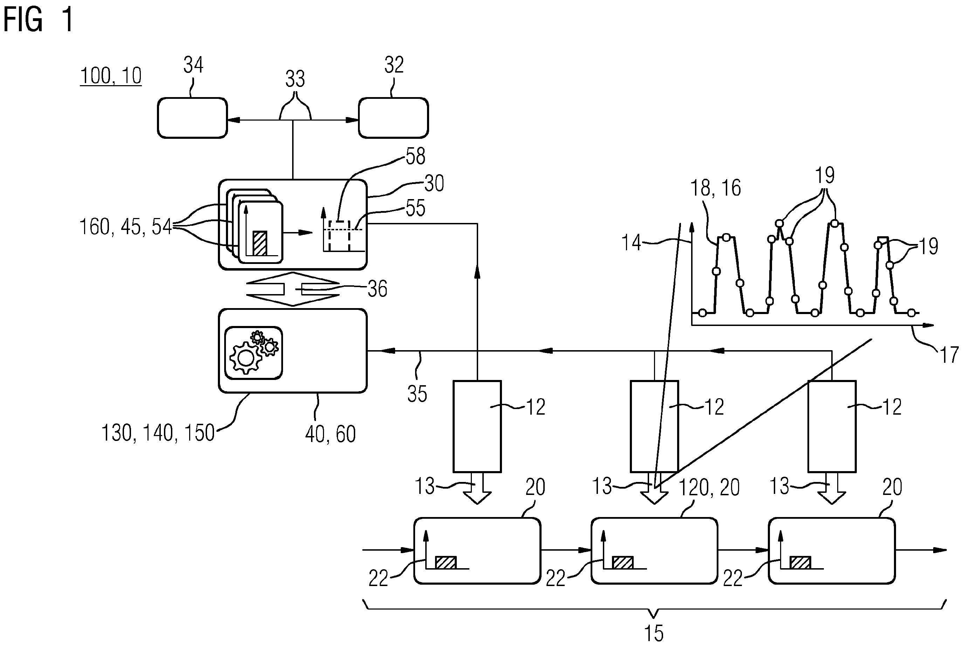

In FIG 1 ist eine erste Ausführungsform des beanspruchten Verfahrens 100 zum Konfigurieren einer Überwachungsvorrichtung 30 in einem ersten Stadium dargestellt. Die Überwachungsvorrichtung 30 gehört zu einer Produktionsanlage 10, auf der ein Produktionsprozess 15 durchführbar ist, in dem Werkstücke 20 bearbeitet werden. Dazu verfügt die Produktionsanlage 10 über eine Mehrzahl an Komponenten 12, die dazu ausgebildet sind, mittelbar oder unmittelbar die Werkstücke 20 zu bearbeiten. Der Produktionsprozess 15 ist als zyklischer Produktionsprozess ausgebildet, so dass die Komponenten 12 je Werkstück 20 im Wesentlichen die gleiche Bearbeitung 13 wiederholt durchführt. Die Werkstücke 20 werden sukzessive stationsweise bearbeitet. Die Komponenten 12 können beispielsweise als Antriebsmotoren für Werkzeuge ausgebildet sein. Die Komponenten 12 der Produktionsanlage 10 sind zu einem Übertragen von Messsignalen 35 kommunikativ mit der Überwachungsvorrichtung 30 und einer Steuereinheit 40 der Produktionsanlage 10 verbunden. Die Steuereinheit 40 und die Überwachungsvorrichtung 30 sind über eine kommunikative Datenverbindung 36 miteinander gekoppelt. Ferner ist läuft auf der Steuereinheit 40 ein Prozessmodell 42 des zugrundeliegenden Produktionsprozesses 15 ab, das einen Digitalen Zwilling 44 der Produktionsanlage 10 umfasst.

Eine von einer Komponente 12 durchgeführte Bearbeitung 13 eines Werkstücks 20 durch zumindest eine Prozess-Variable 16 charakterisiert, die im beanspruchten Verfahren 100 erfassbar ist. Die Prozess-Variable 16 ist eine messbare Größe, die bei einer Bearbeitung 13 des jeweiligen Werkstücks 20 eine Zeitserie 18 bildet. Eine erfasste Prozess-Variable 20 umfasst eine Mehrzahl an Datenpunkten 19, die entlang einer horizontalen Zeitachse 17 die Zeitserie 18 bilden. Dementsprechend liegt für die Datenpunkte 19 jeweils ein Zeitstempel vor. Der Wert der Prozess-Variable 20 ist in FIG 1 an einer vertikalen Größenachse 14 versinnbildlicht. Durch die Bearbeitung 13 der Werkstücke 20 wird bei diesen eine physikalische Größe verändert, die messbar ist und einen Qualitäts-Parameter 22 darstellt. Der Qualitäts-Parameter 22 kann beispielsweise eine Abmessung des Werkstücks 20 sein, die auf ein vorgegebenes Maß zu fertigen ist.

Das Verfahren 100 umfasst einen ersten Schritt 110, in dem eine vorgebbare Prozess-Variable 16 erfasst wird, die an einer der Komponenten 13 vorliegt, beispielsweise eine elektrische Stromstärke an einem Antriebsmotor. Die Prozess-Variable 16 wird bei einer Bearbeitung 13 des jeweiligen Werkstücks 20 durch ein nicht näher gezeigtes Erfassungsmittel an der Komponente 12 erfasst. Die erfasste Prozess-Variabel 16 ist im ersten Schritt 110 in Form eines Messsignals 35 an die Steuereinheit 40 übertragbar. Nach dem ersten Schritt 110 oder teilweise während des ersten Schritts 110 wird ein zweiter Schritt 120 im beanspruchten Verfahren 100 durchgeführt. Darin wird ein vorgebbarer Qualitäts-Parameter 22 am jeweiligen Werkstück 20, das im ersten Schritt 110 bearbeitet wird, erfasst. Hierzu ist die Produktionsanlage 10 mit nicht näher gezeigten geeigneten Erfassungsmitteln versehen.

Durch das beanspruchte Verfahren 100 ist anhand der Prozess-Variable 16 zumindest eine Aggregations-Variable 45 zu ermitteln, die als Vorhersage-Variable 54 für die Überwachungsvorrichtung 30 vorzugeben ist, also in deren Konfiguration einzustellen ist. Hierzu werden ein dritter, vierter und fünfter Schritt 130, 140, 150 mittels der Steuereinheit 40 durchgeführt, die in den folgenden Figuren detaillierter beschrieben sind. Die zumindest eine im fünften Schritt 150 ermittelte Vorhersage-Variable 54 wird in einem sechsten Schritt 160 der Überwachungsvorrichtung 30 vorgegeben. Alternativ oder ergänzend kann auch zumindest einer der Schritte 130, 140, 150 durch eine andere Hardware-Plattform als die Steuereinheit 40 durchgeführt werden.

Bei vorgegebenen Vorhersage-Variablen 54 ist die Überwachungsvorrichtung 30 dazu geeignet, ein Überwachungsverfahren 200 durchzuführen, bei dem ein Prognosewert 58 ermittelt wird, der einem für das jeweilige Werkstück 20 erwarteten Qualitäts-Parameter 22 entspricht. Durch Abgleichen mit einem vorgebbaren Sollwert 55 wird im Überwachungsverfahren 200 ermittelt, ob ein bestimmungswidriger Zustand der Produktionsanlage 10 vorliegt. In Abhängigkeit hiervon kann über eine Benutzerschnittstelle 32, beispielsweise eine visuelle Anzeige oder ein akustisches Signal, eine Warnung 33 an einen Benutzer ausgegeben werden. Alternativ oder ergänzend kann die Warnung 33 auch an eine Datenschnittstelle 34 ausgegeben werden. Die Steuereinheit 40 ist mit einem Computerprogrammprodukt 60 ausgestattet, das dazu ausgebildet ist, zumindest einen der in FIG 1 gezeigten Schritte 110, 120, 130 durchzuführen.

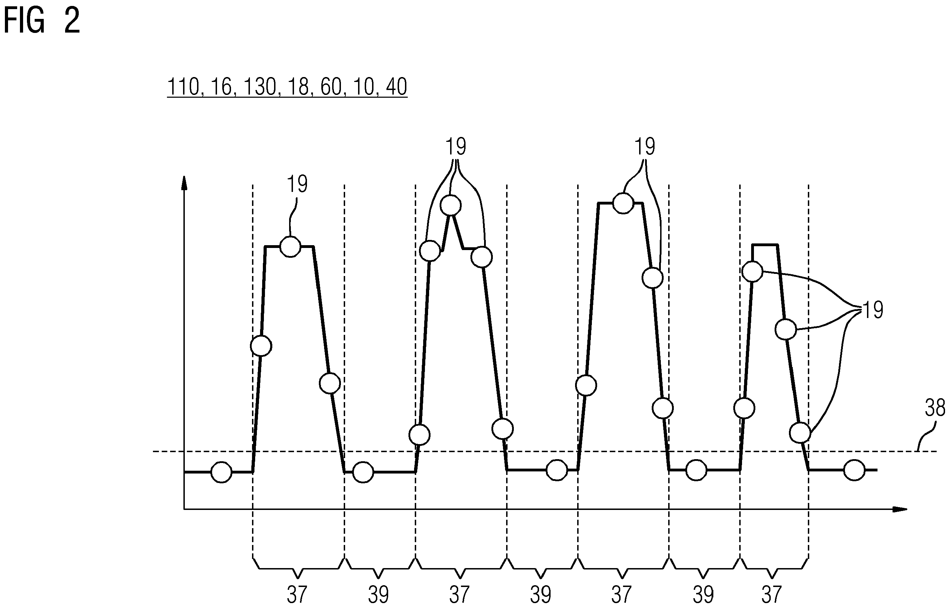

Eine zweite Ausführungsform des beanspruchten Verfahrens 100 ist in FIG 2 während des ersten oder dritten Schritts 130 gezeigt. Es liegt eine in einem ersten Schritt 110, wie beispielsweise in FIG 1 gezeigt, erfasste Prozess-Variable 16 vor, die als Zeitserie 18 ausgebildet ist. Die Prozess-Variable 16 umfasst eine Mehrzahl an Datenpunkten 19, die entlang einer horizontalen Zeitachse 17 geordnet sind. Der Wert der jeweiligen Datenpunkte 19 ist in FIG 2 durch eine vertikale Größenachse 14 dargestellt. Es ist ein einstellbarer Schwellenwert 38 dargestellt, der aus einer weiteren, nicht abgebildeten Prozess-Variable 16 abgeleitet ist. Datenpunkte 19 werden als Datenpunkte 19 erkannt, die zu einer Aktivphase 37 der zugehörigen Komponente 12, und damit des Produktionsprozesses 15, gehören. Datenpunkte 19 unterhalb des Schwellenwerts 38 werden als solche Datenpunkte 19 erkannt, die zu einer Nebenzeitaktion der zugehörigen Komponente 12, und damit das Produktionsprozesses gehören. Solche Nebenzeitaktionen bilden Inaktivphasen 39 des Produktionsprozesses 15 bzw. der zugehörigen Komponente 12 zwischen den Aktivphasen 37. Zur weiteren Verarbeitung der Prozess-Variable 16 werden Datenpunkte 19, die zur Nebenzeitaktion gehören, entfernt und damit im weiteren Verfahren 100 ignoriert. Hierdurch wird gewährleistet, dass im beanspruchten Verfahren 100 die Verarbeitung von Datenpunkten 19 vermieden wird, die zu einer unzutreffenden Prozessphase gehören und somit nicht zur Erkennung einer Voraussage-Variable 54 führen können. Die Aktivphasen 37 entsprechen jeweils Prozessphasen des Produktionsprozesses 15, in denen ein Werkstück 20 bearbeitet wird. Die in FIG 2 gezeigte zweite Ausführungsform ist mit der ersten Ausführungsform des Verfahrens 100, wie in FIG 1 gezeigt, kombinierbar. Die in FIG 2 gezeigten Schritte sind mittels eines nicht näher gezeigten Computerprogrammprodukts 60 zumindest teilweise durchführbar, das auf einer Steuereinheit 40 der Produktionsanlage 10 ausführbar ist.

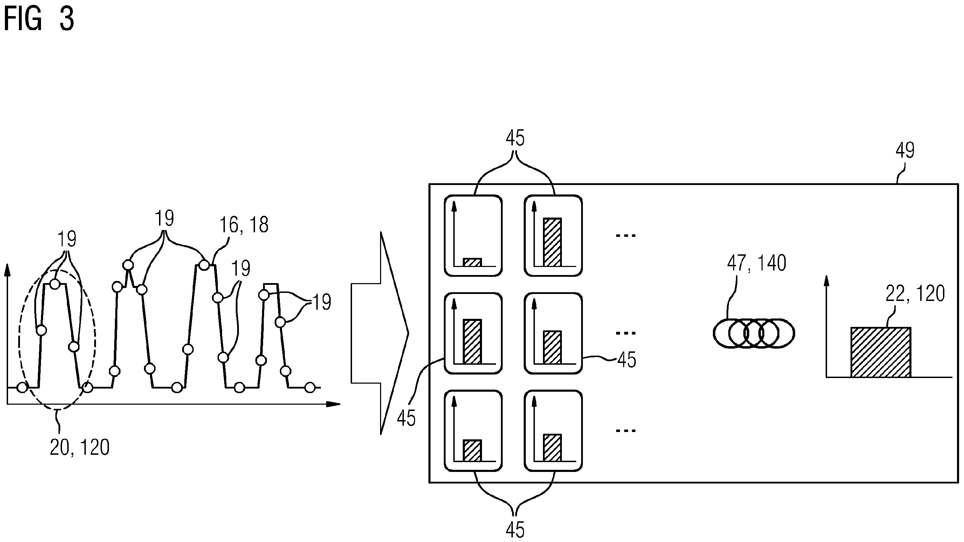

Die erste Ausführungsform des beanspruchten Verfahrens 100 ist in FIG 3 schematisch in einem zweiten Stadium gezeigt, das sich dem in FIG 1 dargestellten ersten Stadium anschließt. Es wird ein dritter Schritt 130 des Verfahrens 100 durchgeführt, in dem die im ersten Schritt 110 erfasste Prozess-Variable 16 in Form einer Zeitserie 18 vorliegt. Darin wird basierend auf der Prozess-Variable 16 eine Mehrzahl an Aggregations-Variablen 45 ermittelt. Das Ermitteln der Aggregations-Variablen 45 erfolgt für Datenpunkte 19 einer Prozessphase, in der ein Werkstück 20 in einem zweiten Schritt 120 bearbeitet wird. Die Aggregations-Variablen 45 stellen eine Verarbeitung der entsprechenden Prozess-Variable 16 dar und weisen jeweils ein geringeres Datenvolumen auf als die Prozess-Variable 16 selbst. Auch in Summe können die Aggregations-Variablen 45 ein geringeres Datenvolumen aufweisen als die entsprechende Prozess-Variable 16. Die Aggregations-Variablen 16 können beispielsweise ein Maximum, ein Minimum, ein arithmetisches Mittel, ein geometrisches Mittel und/oder eine Standardabweichung der Prozessvariable 16 sein, die basierend auf deren Datenpunkten 19 ermittelt werden. Die unterschiedlichen Aggregations-Variablen 45 können im beanspruchten Verfahren 100 fest vorgegeben sein, oder durch einen Algorithmus oder einen Benutzer ausgewählt sein.

Die ermittelten Aggregations-Variablen 45 werden in einem vierten Schritt 140 mit dem Qualitäts-Parameter 22 verknüpft, also kombiniert, der im ersten Schritt 110, wie beispielsweise in FIG 1 gezeigt, erfasst wird. Durch das Kombinieren 47 der Aggregations-Variablen 45 mit dem Qualitäts-Parameter 22 wird ein Werkstück-Datensatz 49 gebildet. Der Werkstück-Datensatz 49 kann ebenfalls ein geringeres Datenvolumen aufweisen als die zugrundeliegende Prozess-Variable 16. Der im vierten Schritt 140 erzeugte Werkstück-Datensatz 49 wird für einen folgenden fünften Schritt 150 bereitgestellt. Die Steuereinheit 40 der Produktionsanlage 10 ist mit einem Computerprogrammprodukt 60 ausgestattet, das dazu ausgebildet ist, zumindest einen der in FIG 3 gezeigten Schritte 130, 140 durchzuführen.

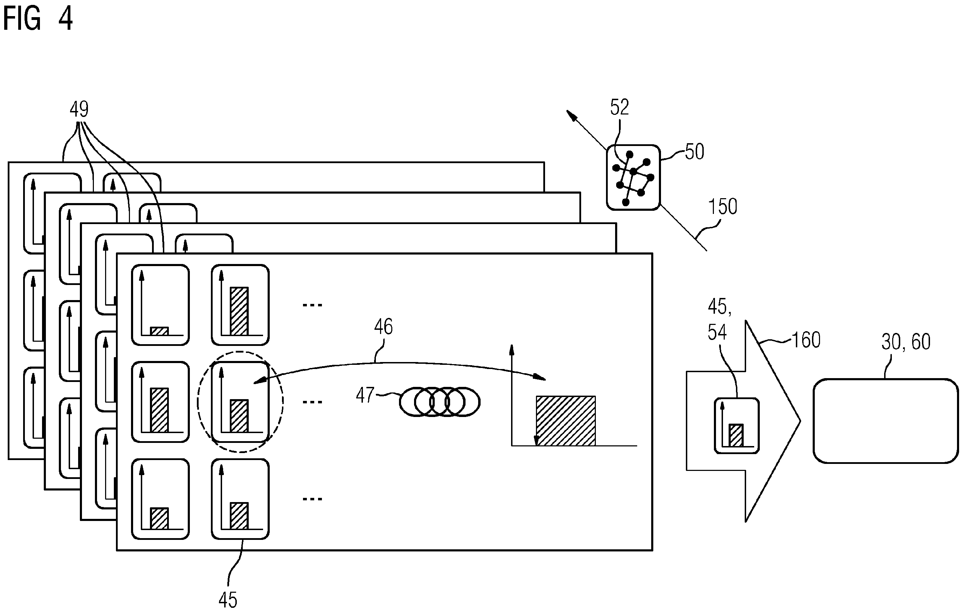

Ein drittes Stadium der ersten Ausführungsform des beanspruchten Verfahrens 100 ist in FIG 4 schematisch abgebildet. Das dritte Stadium folgt auf das in FIG 3 dargestellte zweite Stadium. Das dritte Stadium nach FIG 4 geht davon aus, dass der erste, zweite, dritte und vierte Schritt 110, 120, 130, 140 mehrmals durchgeführt sind und eine Mehrzahl an Werkstück-Datensätzen 49 vorliegt. Jeder der Werkstück-Datensätze 49 umfasst eine Mehrzahl an Aggregations-Variablen 45, die jeweils mit einem Qualitäts-Parameter 22 verknüpft sind. Das Verknüpfen, also das Kombinieren 47, im jeweiligen Werkstück-Datensatz 49 ist im vierten Schritt 140 des Verfahrens 100 erfolgt. Zum dritten Stadium gehört ein fünfter Schritt 150 des Verfahrens 100, in dem die Werkstück-Datensätze 49 von einem Machine-Learning-Modell 50 verarbeitet werden, das beispielsweise als Neuronales Netz 52 ausgebildet ist. Im fünften Schritt 150 werden durch das Machine-Learning-Modell 50 zwischen den Aggregations-Variablen 45 der verarbeiteten Werkstück-Datensätze 49 und dem zugehörigen Qualitäts-Parameter 22 zumindest eine Abhängigkeit 46 ermittelt. Die Abhängigkeit 46 kann über einen nicht näher gezeigten Abhängigkeits-Koeffizienten quantifiziert sein. Anhand der im fünften Schritt 150 erkannten Abhängigkeit 46 wird die zugehörige Aggregations-Variable 45 als Vorhersage-Variable 54 erkannt und ausgewählt. Das Auswählen der Vorhersage-Variable 54 unter den Aggregations-Variablen 45 kann unter anderem am Grad der Abhängigkeit 46, also dem zugehörigen Abhängigkeits-Koeffizienten, erfolgen. Auch das Auswählen der Aggregations-Variable 45 als Vorhersage-Variable 54 ist durch das Machine-Learning-Modell 50 durchführbar.

Die erkannte Vorhersage-Variable 54 wird in einem sechsten Schritt 160 an die Überwachungsvorrichtung 30 übermittelt und damit als zu überwachende Größen für einen Betrieb der Produktionsanlage 10 vorgegeben. Dementsprechend wird die Überwachungsvorrichtung 30 durch das beanspruchte Verfahren 100 konfiguriert. Der fünfte und/oder sechste Schritt 150, 160 werden im beanspruchten Verfahren 100 durch die Steuereinheit 40 durchgeführt. Die Steuereinheit 40 ist mit einem Computerprogrammprodukt 60 ausgestattet, das dazu ausgebildet ist, zumindest einen der in FIG 4 gezeigten Schritte 150, 160 durchzuführen. Alternativ oder ergänzend ist auch zumindest einer der Schritt 150, 160 durch eine andere Hardware-Plattform als die Steuereinheit 40 durchführbar.

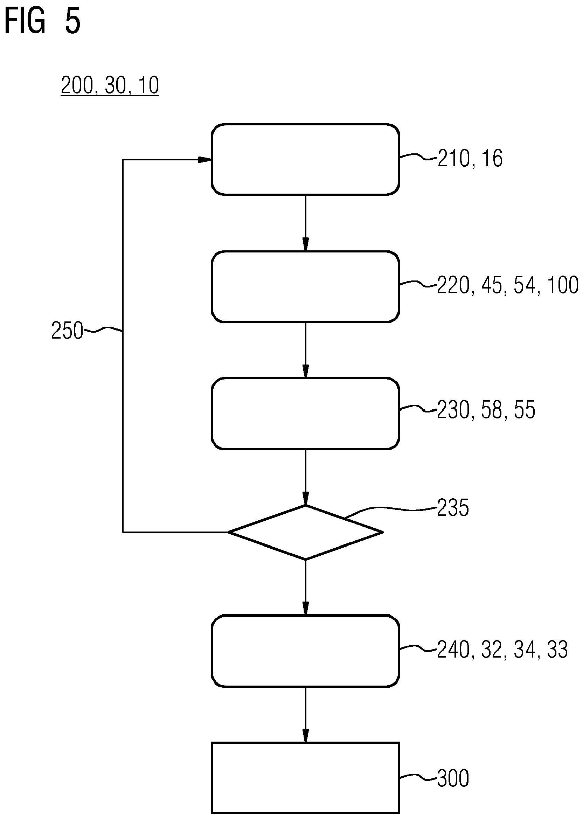

Eine erste Ausführungsform des beanspruchten Überwachungsverfahrens 200 ist schematisch in FIG 5 abgebildet. Das Überwachungsverfahren 200 wird mittels einer Überwachungsvorrichtung 30 einer Produktionsanlage 10 durchgeführt, die zumindest teilweise durch ein beanspruchtes Verfahren 100 konfiguriert ist. Das Überwachungsverfahren 200 umfasst einen ersten Schritt 210, in dem die Produktionsanlage 10 in einem aktiven Betriebszustand bereitgestellt wird und zumindest eine Prozess-Variable 16 erfasst wird. Während des aktiven Betriebszustands wird zumindest ein Werkstück 20 durch die Produktionsanlage 10 bearbeitet. Es folgt ein zweiter Schritt 220, in dem die Prozess-Variable 16 weiterverarbeitet wird und so eine Aggregations-Variable 45 ermittelt wird. Die Aggregations-Variable 45 ist durch die Konfiguration der Überwachungsvorrichtung 30 als Vorhersage-Variable 54, und damit als eine zu überwachende Größe vorgegeben, also eingestellt. Die Vorhersage-Variable 54 ist durch das beanspruchte Verfahren 100 zum Konfigurieren der Überwachungsvorrichtung 30 vorgegeben. Es folgt ein dritter Schritt 230, in dem basierend auf der ermittelten Vorhersage-Variable 54 ein Prognose-Wert 58 ermittelt wird. Der Prognose-Wert 58 stellt einen zu erwartenden Qualitäts-Parameter 22 für das entsprechende Werkstück 20 dar, das im aktiven Betriebszustand während des ersten Schritts 210 bearbeitet wird. Der Prognose-Wert 58 wird mit einem vorgebbaren Sollwert 58 verglichen. Basierend auf dem so durchgeführten Vergleich ergibt sich eine Verzweigung 235 des Überwachungsverfahrens 200. Wird ermittelt, dass der Prognose-Wert 58 den Erfordernissen genügt, die durch den Sollwert 55 definiert sind, wird ein bestimmungsgemäßer Zustand der Produktionsanlage 10 erkannt. Es erfolgt dementsprechend eine Rückführung 250 zum ersten Schritt 210 des Überwachungsverfahren 200. Wird durch den Vergleich zwischen dem Sollwert 55 und dem Prognose-Wert 58 ein bestimmungswidriger Zustand der Produktionsanlage 10 erkannt, schließt sich ein vierter Schritt 240 an. Im vierten Schritt 240 wird über eine Benutzerschnittstelle 32 und/oder eine Datenschnittstelle 34 eine Warnung 33 ausgegeben. Das Überwachungsverfahren 200 erreicht danach einen Endzustand 300.

## Patentansprüche

1. Verfahren (100) zum Konfigurieren einer Überwachungsvorrichtung (30), die zum Überwachen eines Produktionsprozesses (15) in einer Produktionsanlage (10) ausgebildet ist, und die in einem Grundzustand vorliegt, umfassend die Schritte:
a) Erfassen zumindest einer vorgebbaren Prozess-Variable (16) an einer Komponente (12) der Produktionsanlage (10), wobei die Prozess-Variable (16) als Zeitserie (18) ausgebildet ist;
b) Erfassen eines vorgebbaren Qualitäts-Parameters (22) eines Werkstücks (20), das durch die Produktionsanlage (10) bearbeitet ist;
c) Ermitteln von Aggregations-Variablen (45) anhand der Prozess-Variable (16) aus Schritt a);
d) Kombinieren mehrerer der Aggregations-Variablen (45) und des Qualitäts-Parameters (22) in einem Werkstück-Datensatz (49) ;
wobei eine Mehrzahl an Werkstück-Datensätzen (49) nach den Schritten a) bis d) bereitgestellt wird, und
e) Ermitteln je einer Abhängigkeit (46) zwischen je einer Aggregations-Variable (45) und dem Qualitäts-Parameter (22) und Erkennen einer Vorhersage-Variable (54) unter den Aggregations-Variablen (45) anhand der ermittelten Abhängigkeiten (46);
f) Vorgeben der Vorhersage-Variable (54) für den Betrieb der Überwachungsvorrichtung (30) als zu überwachende Größe des Produktionsprozesses (15).

2. Verfahren (100) nach Anspruch 1, **dadurch gekennzeichnet, dass** im Schritt a) anhand eines Zeitstempels der vorgebbaren Prozess-Variable (16) und/oder einer weiteren vorgebbaren Prozess-Variable (16) Datenpunkte (19) ermittelt und entfernt werden, die zu einer Nebenzeitaktion der Komponente (12) der Produktionsanlage (10) gehören.

3. Verfahren (100) nach Anspruch 1 oder 2, **dadurch gekennzeichnet, dass** der Schritt e) mittels eines Machine-Learning-Algorithmus (50) durchgeführt wird.

4. Verfahren (100) nach Anspruch 3, **dadurch gekennzeichnet, dass** der Maschine-Learning-Algorithmus (50) anhand einer Mehrzahl an Werkstück-Datensätzen (22), die gemäß den Schritten a) bis d) bereitgestellt sind, trainiert wird.

5. Verfahren (100) nach einem der Ansprüche 1 bis 4, **dadurch gekennzeichnet, dass** eine der Aggregations-Variablen (45) als Vorhersage-Variable (54) erkannt wird, wenn zwischen der entsprechenden Aggregations-Variablen (54) und dem Qualitätsparameter (45) eine Abhängigkeit mit einem Abhängigkeits-Koeffizienten vorliegt, der betragsmäßig einen vorgebbaren Schwellenwert übersteigt.

6. Verfahren (100) nach einem der Ansprüche 1 bis 5, **dadurch gekennzeichnet, dass** zumindest eine der Aggregations-Variablen (45) als Maximum, Minimum, arithmetisches Mittel, geometrisches Mittel, oder Standardabweichung der zugehörigen Prozess-Variablen (16) ausgebildet ist.

7. Verfahren (100) nach einem der Ansprüche 1 bis 6, **dadurch gekennzeichnet, dass** zumindest eine der Aggregations-Variablen (45) als Koeffizientensatz einer Vergleichsfunktion, als Vergleichswert zu einem Modell-Ausgabewert eines Prozessmodells (42) oder Teilprozessmodells, als Ableitung vorgebbarer Ordnung der Prozess-Variable 816), oder als Prozessunterbrechungsangabe ausgebildet ist, die anhand der Prozess-Variable (16) ermittelt wird.

8. Verfahren (100) nach einem der Ansprüche 1 bis 7, **dadurch gekennzeichnet, dass** die Schritte a) bis f) begleitend zum Produktionsprozess (15) wiederholt durchgeführt werden.

9. Qualitätsprognoseverfahren (200) für einen Produktionsprozess (15), der mittels einer Produktionsanlage (10) mit zumindest einer Komponente (12) durchgeführt wird, umfassend die Schritte:
a) Bereitstellen der Produktionsanlage (10) in einem aktiven Betriebszustand und Erfassen zumindest einer Prozess-Variable (16);
b) Ermitteln zumindest einer Vorhersage-Variable (54) basierend auf der erfassten Prozess-Variable (16);
c) Ermitteln eines Prognosewerts (58) anhand der Vorhersage-Variable (54) für einen Qualitäts-Parameter (22) eines Werkstücks (22) und Vergleichen des Prognosewerts (58) mit einem zugehörigen vorgebbaren Sollwert (55) oder einer vorgebbaren Toleranzgrenze;
d) Ausgeben einer Warnung (33) an einen Benutzer und/oder eine Datenschnittstelle (34), wenn anhand des Vergleichens im Schritt c) ein bestimmungswidriger Zustand der Produktionsanlage (10) erkannt wird;
**dadurch gekennzeichnet, dass** die Vorhersage-Variable (54) mittels eines Verfahrens (100) nach einem der Ansprüche 1 bis 8 vorgegeben ist.

10. Qualitätsprognoseverfahren (200) nach Anspruch 8, **dadurch gekennzeichnet, dass** zumindest Schritt c) durchgeführt wird, während Schritt a) durchgeführt wird oder dass zumindest Schritt c) durchgeführt wird, wenn Schritt a) abgeschlossen ist.

11. Computerprogrammprodukt (60) zum Empfangen von zumindest einer Prozess-Variable (16) und Verarbeiten der zumindest einen Prozess-Variable (45) zum Ermitteln zumindest einer Vorhersage-Variable (54), **dadurch gekennzeichnet, dass** das Computerprogrammprodukt (60) dazu ausgebildet ist, ein Verfahren (100) nach einem der Ansprüche 1 bis 8 zumindest teilweise durchzuführen.

12. Überwachungsvorrichtung (30) zur Überwachen eines Produktionsprozesses (15) an einer Produktionsanlage (10), die dazu ausgebildet ist, zumindest eine Prozess-Variable (45) zu empfangen und anhand der Prozess-Variable (45) zumindest eine Vorhersage-Variable (54) zu ermitteln, **dadurch gekennzeichnet, dass** die zumindest eine Vorhersage-Variable (54) mittels eines Verfahrens (100) nach einem der Ansprüche 1 bis 8 vorgegeben ist.

13. Produktionsanlage (10), umfassend eine Mehrzahl an Komponenten (12), die jeweils zu einem Bearbeiten eines Werkstücks (20) ausgebildet sind, und eine mit den Komponenten (12) verbundene Überwachungsvorrichtung (30), **dadurch gekennzeichnet, dass** die Überwachungsvorrichtung (30) nach Anspruch 12 ausgebildet ist.
